# EUROPEAN PATENT SPECIFICATION

(11) **EP 0 748 535 B1**
(45) Date of publication and mention of the grant of the patent: **27.03.2002**
(21) Application number: 94902177.8
(22) Date of filing: 30.09.1993
(51) Int. Cl.: H03K 5/24, G11C 16/00, G05F 1/565

(54) **IMPROVED SUPPLY VOLTAGE DETECTION CIRCUIT**
SPEISESPANNUNGSDETEKTORSCHALTUNG
CIRCUIT DE DETECTION DE TENSION AMELIORE

(43) Date of publication of application: 18.12.1996
(73) Proprietor: Macronix International Co., Ltd., Hsinchu (TW)
(72) Inventor: LIN, Tien-Ler, Cupertino, CA 95014 (US); YIU, Tom, Dang-Hsing, Milpitas, CA 95035 (US)
(74) Representative: Brookes Batchellor
(86) International application number: US9309321
(87) International publication number: WO9509483

(56) References cited:
- US-A- 4 321 489
- US-A- 4 441 172
- US-A- 4 473 759
- US-A- 4 613 770
- US-A- 4 812 680
- US-A- 4 975 883
- US-A- 5 003 196
- US-A- 5 053 990
- US-A- 5 172 342
- US-A- 5 180 926
- US-A- 5 208 488
- US-A- 5 243 233
- US-A- 5 276 646
- US-A- 5 280 198

## Description

### BACKGROUND OF THE INVENTION

### Field Of The Invention

The present invention relates to circuits for monitoring power supply voltage levels in the field of nonvolatile memory devices.

### Description Of Related Art

Flash EPROMs are a growing class of nonvolatile storage integrated circuits. These flash EPROMs have the capability of electrically erasing, programming or reading a memory cell in the chip. The entire array can be simultaneously erased electrically. The flash EPROM can also be randomly read or written.

The cells themselves use only a single device per cell and are formed using so-called floating gate transistors in which the data is stored in a cell by charging or discharging the floating gate. The floating gate is a conductive material, typically made of polysilicon, which are insulated from the channel of the transistor by a thin layer of oxide or other insulating material, and insulated from the control gate wordline of the transistor by a second layer of insulating material.

The act of charging the floating gate is termed the "program" step for a flash EPROM. This is accomplished through a so-called hot electron injection by establishing a large positive voltage between the gate and source, as much as 12 volts, and a positive voltage between the drain and source, for instance, 6 volts.

The act of discharging the floating gate is called the "erase" function for a flash EPROM. This erasure function is typically carried out by a Fowler-Nordheim (F-N) tunneling mechanism between the floating gate and the source of the transistor (source erase) or between the floating gate and the substrate (channel erase). For instance, a source erase operation is induced by establishing a large positive voltage from the source to gate, while floating the drain of the respective memory cell. This positive voltage may be as much as 12 volts.

Given that flash EPROMs can be programmed or erased by applying voltage to the device, systems incorporating flash EPROMs often design capabilities to program and erase the flash EPROMs. In order for a system to provide capabilities to program and erase the flash EPROMs, the system has to provide not only a Vcc voltage but also a Vpp voltage. Vcc is generally a 5 volt supply for controlling the logic in the read mode of the nonvolatile memory device. Vpp is a 12 volt supply used in combination with Vcc for controlling the programming and erasing modes of the nonvolatile memory device.

A problem arises when the computer system which uses nonvolatile memory as part of its storage elements goes through a power up or power down sequence. A power up sequence refers to the moment a user starts the computer system, while a power down sequence refers to the moment a user turns off the computer system. During these power up and power down sequences, the system power supplies for Vcc and Vpp rise and fall through their proper operating ranges. When this occurs, control signals within the system are not guaranteed to be valid. These invalid signals can cause inadvertent programming or erasing of the nonvolatile data. In certain instances, permanent damage to the nonvolatile memory can occur.

Protection circuits have been designed to prevent the application of Vcc voltage or Vpp voltage to the nonvolatile device when the voltages are below the proper operating level. One such system is disclosed in Baker, et al., U.S. Patent No. 4,975,883, issued December 4, 1990. Baker, et al. uses two comparators to detect the proper voltage level. One for the Vcc voltage and one for the Vpp voltage. The comparators constantly dissipate a substantial amount of DC power. Further, many of the devices in the voltage detector of Baker, et al. are exposed to the high Vpp voltage. Devices subjected to the high voltage of Vpp require additional protection to reduce the stress on such components. Also, to reduce power dissipation, longer channel devices are needed which take significant space on the chip. Accordingly, disadvantages of Baker, et al. include comparators that dissipate DC power, requirement that circuits provide for high voltage protection, and the overall complexity of the detection circuit.

Therefore, it is desirable to design a voltage protection circuit that improves and overcomes the disadvantages of the prior art.

### SUMMARY OF THE INVENTION

The present invention provides a circuit to detect when a voltage is below a predetermined voltage level
According to the present invention, a voltage detection circuit comprises a high voltage input to receive a high supply voltage and a low voltage input to receive a low supply voltage. A reference circuit is coupled to the high voltage input and the low voltage input and provides a reference voltage in response to the high voltage input or the low voltage input. A low voltage detector is coupled to the low voltage input and the reference voltage and has circuitry to provide a first not-ready signal when a voltage on the low voltage input falls below a predetermined low voltage threshold. A high voltage detector is coupled to the
high voltage input, the reference voltage, and the output of the low voltage detector and has circuitry to provide a second not-ready signal when either the first not-ready signal is received or a voltage on the high voltage input falls below a predetermined high voltage threshold.
In order to avoid subjecting devices of the voltage detection circuit to the high voltage input, the reference circuit, according to one aspect of the invention, includes circuitry coupled to the high voltage input having an output node to reduce the high supply voltage to a node voltage for the output node and a circuit that supplies the reference voltage as a function of the greater of the node voltage or the low supply voltage. Using this technique, the high voltage input is reduced to a level similar to the low voltage input.

The low voltage detector, according to another aspect of the invention, includes a threshold inverter having a trip voltage set to the predetermined low voltage threshold. The threshold inverter includes a transistor device having a channel with a length and a width to set the trip voltage for the threshold inverter of the low voltage detector. The low voltage detector includes circuitry coupled to the low voltage input to provide a voltage to the threshold inverter. The low voltage detector includes a hysteresis circuit, coupled to the threshold inverter, to provide a first predetermined voltage threshold when the low voltage input exceeds the first voltage threshold and a second predetermined voltage threshold when the low voltage input falls below the second voltage threshold. The low voltage detector includes an output buffer, coupled to the hysteresis circuit, to provide the first notready signal.

The high voltage detector includes a threshold inverter having a trip voltage set to the predetermined high voltage threshold. The threshold inverter of the high voltage detector includes a transistor device having a channel with a length and a width to set the trip voltage for the threshold inverter of the high voltage detector. The high voltage detector includes threshold logic, coupled to the threshold inverter and the first not-ready signal, to provide a threshold signal in response to the threshold inverter and the first not-ready signal. The high voltage detector includes an output buffer responsive to the threshold signal to provide the second not-ready signal.

The invention can also be characterized as a voltage detector comprising a reference circuit having a first voltage on a first input and a second voltage on a second input and circuitry to reduce the second voltage to a node voltage and to supply a reference voltage in response to the greater of the first voltage or the node voltage. A first voltage detection circuit is powered by the reference voltage and is responsive to the first voltage to provide a first signal when the first voltage is below the first predetermined voltage. A second voltage detection circuit is powered by the reference voltage and is responsive to the second voltage to provide a second signal when the second voltage is below the second predetermined voltage and when the first signal is asserted.

The circuitry of the reference circuit implements a voltage divider to reduce the second voltage to the node voltage. MOS devices are used to implement the voltage divider. The second voltage detection circuit, according to another aspect of the invention, has a first input, coupled to the first signal of the first voltage detection circuit, and a second input, coupled to the second voltage, and is responsive to the first signal and the second voltage to provide the second signal.

The first voltage detection circuit includes a threshold detector set at the first predetermined voltage to provide the first signal when the first voltage is below the first predetermined voltage. The first voltage detection circuit includes a hysteresis circuit, coupled to the threshold detector, to provide the first signal at a third predetermined voltage when the first voltage falls below the third predetermined voltage.

The second voltage detection includes a diode device, coupled to the second voltage, to reduce the second voltage to a third voltage. A control circuit, coupled to the third voltage and the reference voltage, provides an input voltage when the third voltage is greater than the reference voltage. A threshold circuit having a threshold voltage set at the second predetermined voltage is responsive to the input voltage to provides a threshold signal. The second voltage detection circuit includes a voltage converter, coupled to the threshold detector, responsive to the threshold voltage to provide the second signal. Since both the first voltage and the second voltage have to exceed their predetermined minimum voltages before the second signal is provided, the second signal can be used to enable erasing and programming operations of the flash EPROM. The voltages are at proper operating levels to insure proper operation of the flash EPROM circuits.

Flash EPROMs are used in many applications. The invention can be characterized as a processing system comprising a power supply generating a first output for programming supply voltage and a second output for read supply voltage. A reference supply, coupled to the first output and the second output, provides a reference voltage in response to the greater of the programming supply voltage or the read supply voltage. A first voltage detector is powered by the reference voltage and is responsive to the read supply voltage to provide a first signal when the read supply voltage falls below a first predetermined voltage threshold. A second voltage detector is powered by the reference voltage and is responsive to the programming supply voltage and the first signal to provide a second signal when either the programming supply voltage falls below a second predetermined voltage threshold or when the first signal is provided. A memory, coupled to the power supply, the first voltage detector, and the second voltage detector, stores data and program instructions and is responsive to the first or second signals to control access of the memory. A processing unit, coupled to the power supply and to the memory, accesses data and program instructions in the memory to process the data and program instructions.

According to another aspect of the invention, the reference supply includes a voltage reduction circuit, coupled to the programming voltage of the power supply, which provides an intermediate voltage in response to the programming voltage. The reference supply provides the reference voltage in response to the greater of the intermediate voltage or the read voltage. The second voltage detector has an input to receive the first signal and is responsive to the first signal to provide the second signal.

According to another aspect of the invention, the memory includes a nonvolatile memory that can be erased and programmed when the programming voltage is provided to the memory. The nonvolatile memory can be placed into a read only mode in response to the first signal. The second signal of the second voltage detector disables erase and programming functions to the memory.

The present invention is particularly suited for control circuits in a nonvolatile memory device that is programmable by the application of programming voltage. The invention will prevent inadvertent erasure or programming of the nonvolatile device during power up or power down sequences when control signals are unstable or in a unknown state. Thus, the use of the preferred embodiment of the present invention affords greater protection against accidental erasure and programming of the nonvolatile memory devices.

Other aspects and advantages of the present invention can be seen upon review of the figures, the detailed description and the claims which follow.

### BRIEF DESCRIPTION OF THE DRAWINGS

Fig. 1 is a block diagram of the Vcc/Vpp voltage detection circuit.
Fig. 2 is a circuit diagram of the detector power supply.
Fig. 3 is a simplified circuit diagram for the detector power supply.
Fig. 4 is a graph of the voltage at node 11 versus Vpp.
Fig. 5 is a circuit diagram of the low Vcc detector.
Fig. 6 is a simplified circuit diagram of the low Vcc detector.
Fig. 7 is a circuit diagram of the high Vpp detector.
Fig. 8 is a simplified diagram of the high Vpp detector.
Fig. 9 is a conceptual block diagram of a processing system according the present invention.
Fig. 10 is a diagram illustrating the operating range of the Vcc/Vpp voltage detection circuit 10 for preventing the erasure and programming of a nonvolatile memory device used in a processing system.

### DETAILED DESCRIPTION OF THE INVENTION

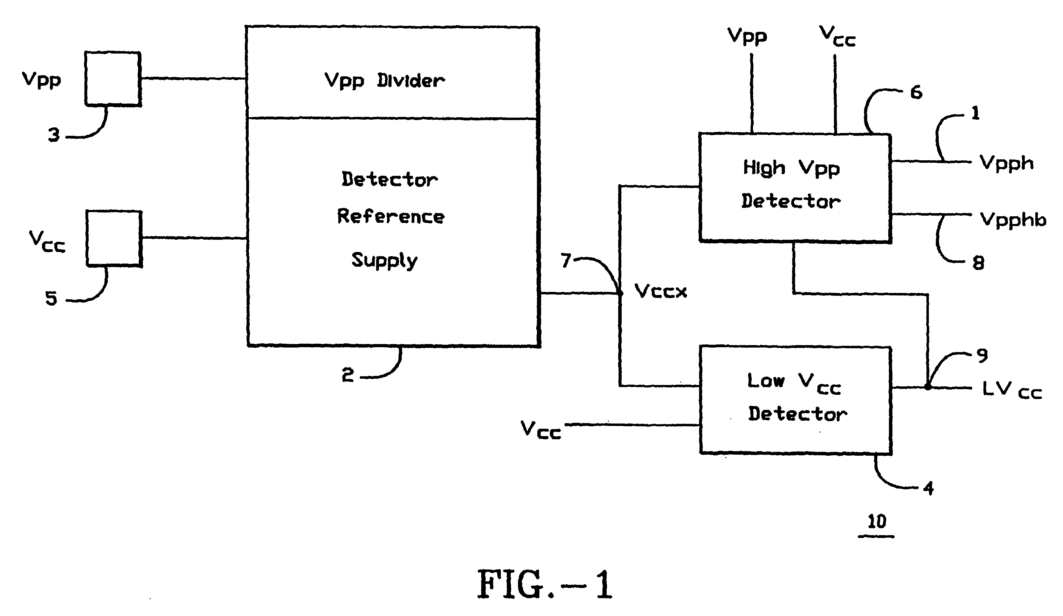

An overview of a preferred embodiment of a voltage detection circuit is illustrated in Fig. 1. Fig. 1 depicts Vcc/Vpp detection circuit 10. Detector reference supply 2 is coupled to Vcc at Vcc pad 5. Detector reference supply 2 includes a Vpp divider and is coupled to Vpp at Vpp pad 3. Detector reference supply 2 provides an output Vccx 7. Low Vcc detector 4 receives inputs from Vcc and Vccx 7 and provides an output LVcc 9. High Vpp detector 6 receives inputs from Vccx 7, Vpp, Vcc, and LVcc 9. The outputs of high Vpp detector 6 are Vpph 1 and Vpphb 8.

The Vcc/Vpp detection circuit 10 detects the occurrence of low voltage on either the Vpp or the Vcc supply voltage. Upon detection of low voltage, Vcc/Vpp detection circuit 10 provides a low Vpph 1 signal or a high LVcc 9 signal corresponding to the low voltage. Detector reference supply 2 supplies reference voltage Vccx 7 to low Vcc detector 4 and high Vpp detector 6. Low Vcc detector 4 is coupled to Vcc and is operative to determine whether Vcc is below a predetermined minimum voltage level. The minimum voltage level is set at the minimum voltage at which circuits can sustain proper operation. If the Vcc voltage applied to the low Vcc detector 4 is below the predetermined minimum voltage, low Vcc detector 4 causes signal LVcc 9 to a high logic level.

The high Vpp detector 6 detects when the Vpp input voltage is below a predetermined threshold voltage level. High Vpp detector 6 causes Vpph 1 to a high logic level when the Vpp input is above the predetermined minimum voltage and LVcc is asserted. Output signal Vpphb 8 is the complement of Vpph 1.

LVcc 9 is coupled to high Vpp detector 6 and causes Vpph to be a low logic level even when Vpp is at a voltage level above the predetermined voltage. This feature is advantageous to prevent invalid 5 volt control signals from inadvertently altering the nonvolatile memory when Vpp is sufficiently high.

For example, some nonvolatile memory devices which include EPROMs, EEPROMs and flash memory devices can be reprogrammed when the memory receives an externally generated erasing/programming potential Vpp of approximately 12 volts. If the Vcc voltage is below the predetermined minimum, circuits powered by Vcc may operate in an unpredictable manner. To avoid the occurrence of inadvertent programming of the nonvolatile memory while control signals relying on Vcc are not guaranteed valid, high Vpp detector 6 receives signal LVcc 9 and is responsive to LVcc 9 to inhibit Vpph from asserting a high logic level when low Vcc detector 4 detects a low Vcc voltage.

Vcc/Vpp detection circuit 10 is fabricated using metal-oxide-semiconductor (MOS) processing. More specifically, complimentary metal-oxide-semiconductor (CMOS) technology is used to fabricate the transistor devices shown in the figures. N-type devices are formed in a p-substrate and p-type devices are formed in the n-wells, the n-wells being first formed in the p-substrate. NZ devices are also depicted in the figures. An NZ device is a n-channel device with a threshold voltage of approximately 0.0 volts.

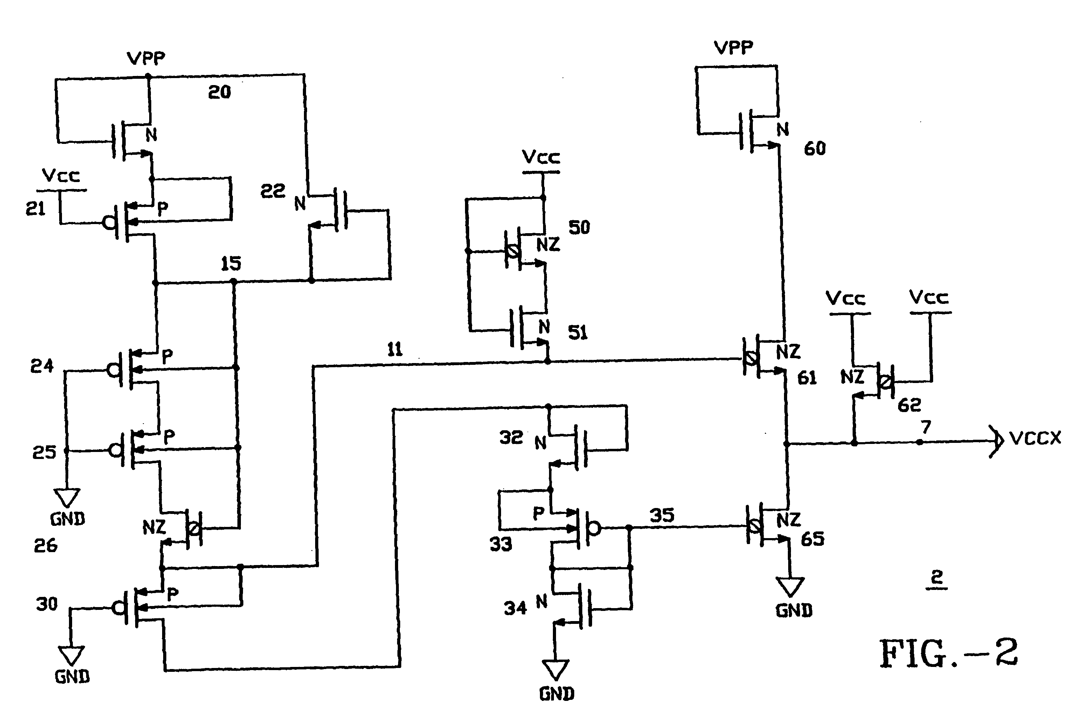

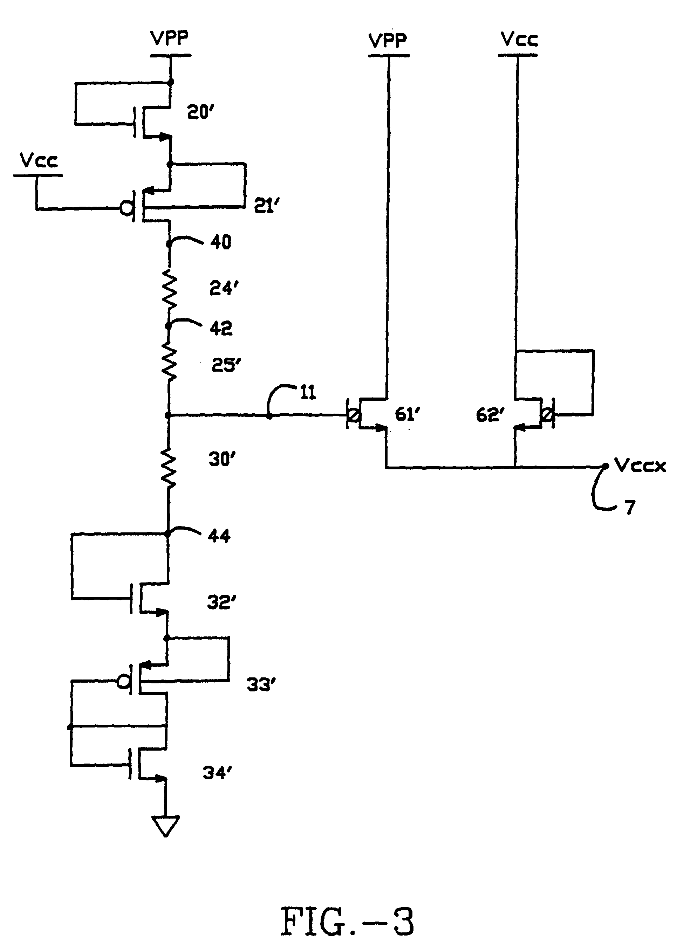

Fig. 2 is a circuit diagram of detector power supply 2. The operation of detector power supply 2 is explained with reference to Fig. 3.

Fig. 3 depicts a simplified circuit for detector power supply 2. Vpp is coupled to the drain and gate of n-channel device 20'. The source of n-channel device 20' is coupled to the source and substrate of p-channel device 21'. The gate of p-channel device 21' is coupled to Vcc, and the drain is coupled to node 40. Resistive device 24' is coupled between nodes 40 and 42. Resistive device 25' is coupled between nodes 42 and 11. Resistive device 30' is coupled between nodes 11 and 44. The drain and gate of n-channel device 32' are coupled to node 44, and the source of n-channel device 32' is coupled to the substrate and source of p-channel device 33'. The drain and gate of p-channel device 33' are coupled to the drain and gate of n-channel device 34'. The source of n-channel device 34' is coupled to ground. The drain of NZ device 61' is coupled to Vpp, and the gate is coupled to node 11. The drain and gate of NZ device 62' are coupled to Vcc. The sources of NZ devices 61' and 62' are coupled to output Vccx 7.

Vpp provides the input power for the output at node 11. Devices 20', 21', 32', 33' and 34' are configured to function as diode voltage drop elements. Devices 24', 25' and 30' are configured to function as resistive elements. Table I gives relative width and length dimensions in microns that correspond to devices depicted in the figures 2, 5 and 7. Referring to Table I, the lengths of devices 24, 25 and 30 of Fig. 2 are ten times longer than the width. The devices operate in their linear region, functioning as a resistor. Node 11 is the output from the Vpp input.

**TABLE I**

| DEVICE # | WIDTH | LENGTH |
|---|---|---|
| 20 | 30 | 2 |
| 21 | 30 | 2 |
| 22 | 8 | 2 |
| 24 | 4 | 40 |
| 25 | 4 | 40 |
| 26 | 4 | 4 |
| 30 | 4 | 40 |
| 32 | 30 | 1.4 |
| 33 | 60 | 1.6 |
| 34 | 30 | 1.4 |
| 50 | 4 | 160 |
| 51 | 4 | 2 |
| 60 | 200 | 2 |
| 61 | 160 | 3 |
| 62 | 100 | 3 |
| 65 | 2 | 200 |
| 110 | 8 | 1.2 |
| 111 | 20 | 1.6 |
| 112 | 10 | 1.4 |
| 113 | 4 | 15 |
| 116 | 3.5 | 100 |
| 117 | 15 | 10 |
| 119 | 8 | 1.2 |
| 130 | 3 | 60 |
| 131 | 20 | 2 |
| 132 | 10 | 10 |
| 140 | 5 | 2 |
| 141 | 15 | 2 |
| 142 | 5 | 8 |
| 150 | 15 | 2 |
| 151 | 15 | 2 |
| 210 | 10 | 3 |
| 211 | 30 | 3 |
| 220 | 30 | 2 |
| 221 | 30 | 2 |
| 222 | 5 | 30 |
| 223 | 5 | 30 |
| 230 | 4 | 15 |
| 231 | 15 | 3 |
| 232 | 10 | 2 |
| 233 | 10 | 2 |
| 234 | 10 | 2 |
| 235 | 5 | 2 |
| 240 | 10 | 2 |
| 241 | 10 | 2 |
| 250 | 10 | 2 |
| 251 | 10 | 2 |
| 260 | 4 | 6 |
| 261 | 12 | 2 |
| 262 | 4 | 6 |
| 263 | 12 | 2 |

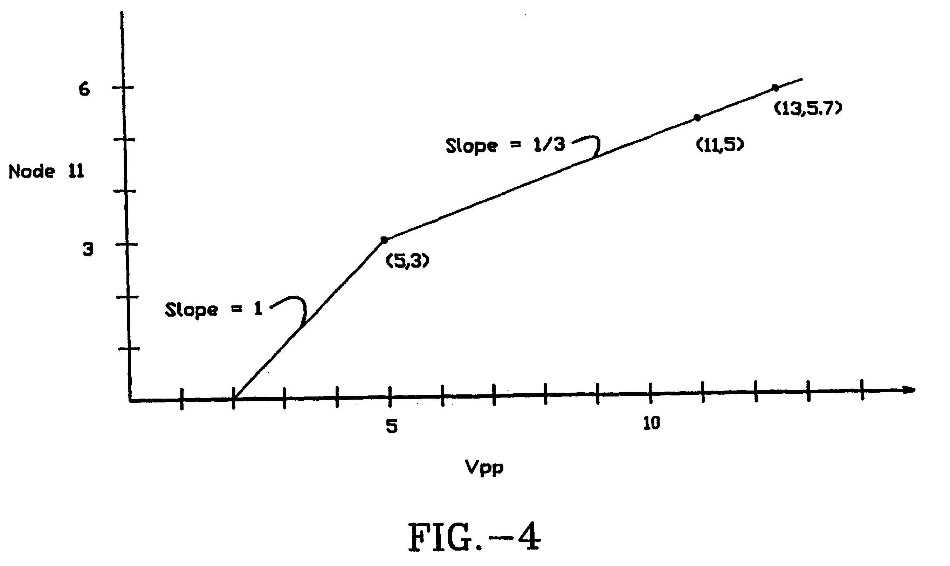

Fig. 4 shows a graph of node 11 versus Vpp as Vpp goes from 0 volts to 13 volts, assuming Vcc is 0 volts. Vpp has to be greater than 2 volts before node 11 has a voltage. This is caused by diode devices 20' and 21'. The 2 volts drop corresponds to the 1 volt threshold voltage drop per MOS device. Thus, each diode device accounts for 1 volt drop. Once Vpp overcomes the 2 diodes drops of device 20' and device 21', voltage is detected at node 11. As Vpp increases, the voltage at node 11 increases in proportion with the increase. Devices 32', 33' and 34' acting as diodes prevent a voltage drop across resistive devices 24', 25' and 30'. Thus, until Vpp reaches 5 volts, diode devices 32', 33' and 34' cause the voltage at node 11 to correspond with the increase of Vpp.

As Vpp voltage increases above 5 volts, the resistive devices 24', 25' and 30' function as a voltage divider to reduce the voltage of node 11. As shown in Table I, devices 24, 25 and 26 of Fig. 2 are similarly configured having the same width and length. Thus, the voltage at node 11 is reduced by 2/3. Fig. 4 graphically illustrates the voltage at node 11 as Vpp increases above 5 volts. For example, when Vpp is at 11 volts, node 11 is at 5 volts. Similarly, when Vpp is at 13 volts, node 11 is at 5.7 volts. Referring to Fig. 3, device 61' and device 62' are configured to function as a wire-or. Device 62' is a NZ device coupled to Vcc and the output Vccx 7. Thus, NZ device 62' couples Vcc to Vccx 7. NZ device 61' is coupled to node 11 and the output Vccx 7. The greater of node 11 or Vcc is applied at the output Vccx 7 as the output supply power for detector power supply 2.

Referring to Fig. 2, devices 20, 21, 24, 25, 30, 32, 33, 34, 61 and 62 correspond to devices 20', 21', 24', 25', 30', 32', 33', 34', 61' and 62' of Fig. 3. The drains of n-channel devices 20 and 22 are coupled to Vpp. The gate of device 20 is also coupled to Vpp. The source and substrate of p-channel device 21 are coupled to the source of n-channel device 20 and the gate of p-channel device 21 is coupled to Vcc. N-channel device 22 is configured as a reverse diode to discharge node 15 when Vpp is not active. Node 15 is the junction for the drain of p-channel device 21, the source and gate of n-channel device 22, the gate of NZ device 26, the source and substrate of p-channel device 24 and the substrate of p-channel device 25. The gates of p-channel device 24 and p-channel device 25 are coupled to ground. The drain of p-channel device 24 is coupled to the source of p-channel device 25. The drain of NZ device 26 is coupled to the drain of p-channel device 25, and the source of NZ device 26 is coupled to the source and substrate of p-channel device 30. The gate of p-channel device 30 is coupled to ground while the drain is coupled to the drain and gate of n-channel device 32. The source of n-channel device 32 is coupled to the source and substrate of p-channel device 33. Node 35 is the junction of the gate and drain of p-channel device 33 and the gate and drain of n-channel device 34 and the gate of NZ device 65. The source of n-channel device 34 is coupled to ground. NZ device 50 is configured like a diode with the gate and the drain coupled to Vcc. The source of NZ device 50 is coupled to the drain of n-channel device 51. The gate of n-channel device 51 is coupled to Vcc while the source of n-channel device 51 is coupled to node 11.

Devices 50 and 51, through Vcc, function to maintain node 11 so that the voltage on node 11 does not float. Since node 11 is primarily driven by Vpp, a low Vpp voltage can cause node 11 to float or have an indeterminate value. NZ device 50 and n-channel device 51 are configured to permit a small amount of current to flow to node 11. NZ device 50 has a length of 160 and a width of 4. The length is 40 times longer than the width of the device. Thus, device 50 is very resistive and very little current flows to node 11.

NZ device 26 is configured as a reverse diode to prevent Vcc current flowing from devices 50 and 51 and forward bias the drain junction of P-device 25 when Vpp is not active.

NZ device 62 provides the Vcc input to output Vccx 7. The drain and gate of device 62 are coupled to Vcc while the source is coupled to Vccx 7. Since device 62 is a NZ device, the output voltage of Vccx 7 is equal to Vcc. The source of NZ device 61 is also coupled to Vccx 7. The gate of NZ device 61 is coupled to node 11 while the drain is coupled to the source of n-channel device 60. The gate and drain of n-channel device 60 are coupled to Vpp. As mentioned above, NZ device 61 functions as a wire-or of node 11 or Vcc. The greater of the voltage at node 11 or at the source of NZ device 62 is supplied as the output for Vccx 7.

N- channel device 60 is added to reduce voltage stress on NZ device 61. The threshold voltage drop for device 60 is 1.5 volts. The drain of NZ device 65 is also coupled to vccx 7. The gate is coupled to node 35 and the source is coupled to ground. NZ device 65 discharges the voltage at Vccx 7 when both Vpp and Vcc are at ground. Device 65 is configured to source very little current. As shown in Table I, the length of device 65 is 100 times longer than the width. Thus, device 65 is very resistive, and very little current flows to ground.

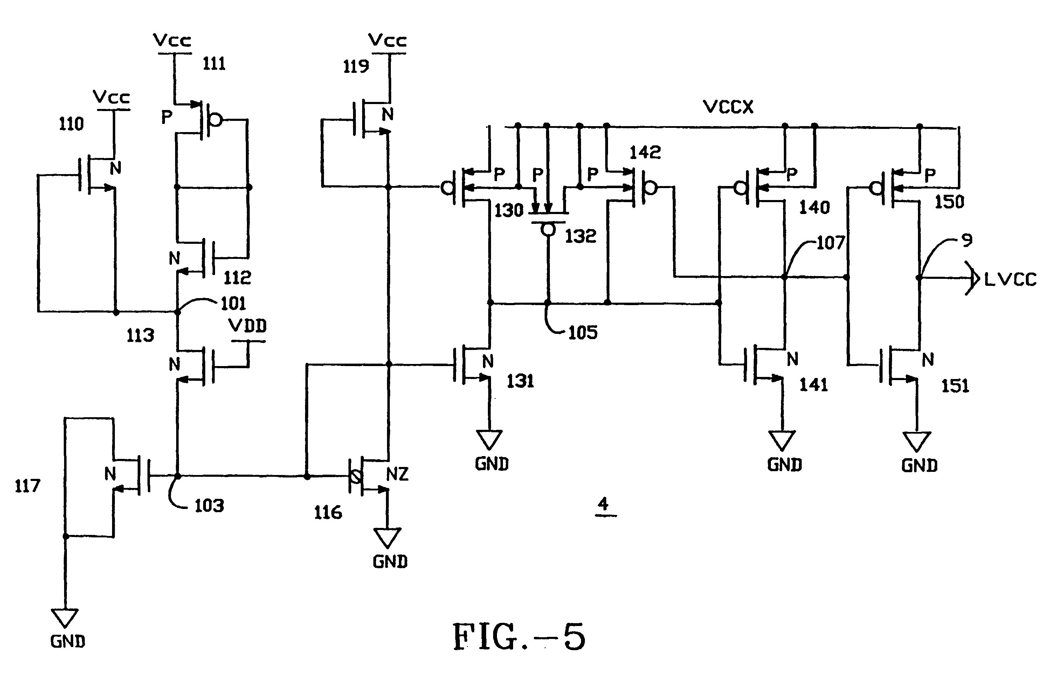

Fig. 5 is a circuit diagram of low Vcc detector 4. Vccx 7 supplies the power for low Vcc detector 4. The output signal LVcc 9 is at a high logic level when Vcc is detected low and is at a low logic level when Vcc is detected above 3 volts.

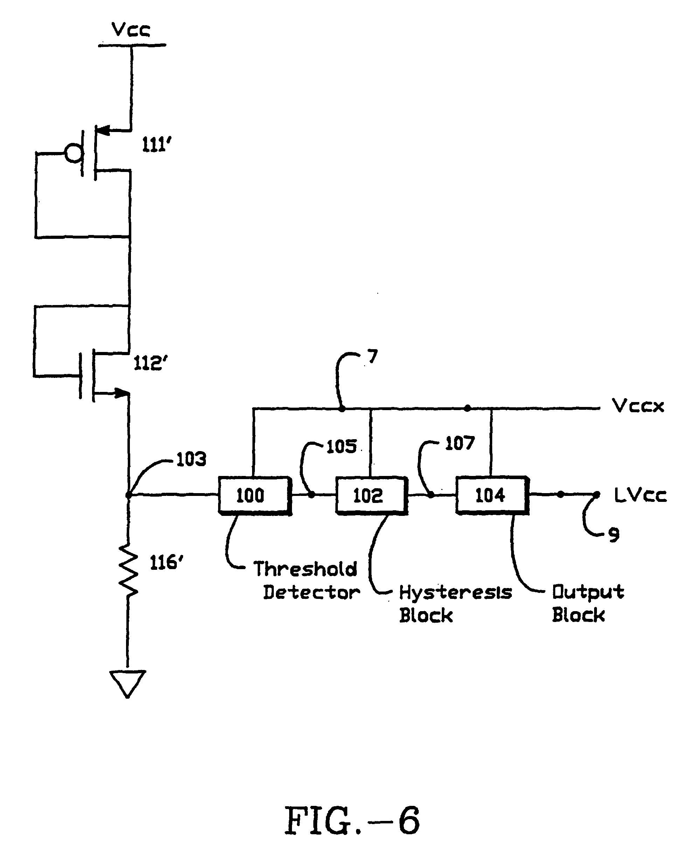

Fig. 6 is a simplified diagram of Low Vcc detector 4. The source of p-channel device 111' is coupled to Vcc. The gate and drain of device 111' are coupled to the gate and drain of n-channel device 112'. The source of n-channel device 112' is coupled to node 103. Resistive device 116' is coupled between node 103 and ground. The input of threshold detector 100 is coupled to node 103, and the output is coupled to node 105. The input of hysteresis block 102 is coupled node to 105, and the output is coupled to node 107. The input of output block 104 is coupled to node 107, and the output is coupled to LVcc 9. Threshold detector 100, hysteresis block 102, and output block 104 are coupled to Vccx 7.

Device 111' and device 112' function as diode voltage drop elements. Device 116' is very resistive. Referring to Table I, the length of NZ device 116 of Fig. 5 is almost 30 times longer than the width. Vccx 7 supplies the power for threshold detector 100, hysteresis block 102, and output block 104. Threshold detector 100 is represented by p-channel device 130 and n-channel device 131 of Fig. 5. As shown in Table 1, the dimensions of p-channel device 130 differ with n-channel device 131. Threshold detector 100 sets the threshold voltage for low Vcc detector 4. Thus, the threshold voltage for low Vcc detector 4 can be varied according to the dimensions of the devices. The voltage drop across device 116' is applied to detector 100. The trip voltage for detector 100 is set at 1.3 volts. Device 111' and device 112' functioning as diode elements reduce the Vcc input by 2 volts. Thus, whenever Vcc is below 3.3 volts, the output of LVcc 9 is a high logic level. Hysteresis block 102 is represented by p-channel devices 140, 142, and n-channel device 141 of Fig. 5. Output block 104 is represented by p-channel device 150 and n-channel device 151 of Fig. 5. Threshold detector 100, hysteresis block 102, and output block 104 are comprised of inverters using CMOS technology. Thus, low Vcc detector 4 dissipates very little power.

Referring to Fig. 5, devices 111, 112 and 116 correspond to devices 111', 112' and 116' of Fig. 6. The source of p-channel device 111 is coupled to Vcc. The gate and drain of p-channel device 111 are coupled to the drain and gate of n-channel device 112. The drain of n-channel device 110 is coupled to Vcc. The source and gate of n-channel device 110 are coupled to node 101. N-channel device 110 is configured as a reversed biased diode to discharge node 101 when Vcc is not active.

The drain of n-channel device 113 is coupled to node 101 and to the source of n-channel device 112. The gate of n-channel device 113 is coupled to Vcc, and the source is coupled to node 103 and to the gate of n-channel device 117. The drain and source of n-channel device 117 are coupled to ground. Device 113 and device 117 are used for AC timing. The devices provide a RC time constant to slow the 0 to 5 volts transition of Vcc when Vcc rises to 5 volts too fast.

The drain of n-channel device 119 is coupled to Vcc, and the gate and source of n-channel device 119 are coupled to node 103. The gate and drain of NZ device 116 are coupled to node 103, and the source is coupled to ground. Device 116 is highly resistive. N-channel device 119 is configured as a reversed biased diode to discharge node 103 when Vcc is not active.

The source and substrate of p-channel device 130 are coupled to Vccx 7, and the gate is coupled to node 103. The drain of n-channel device 131 is coupled to the drain of p-channel device 130. The gate of n-channel device 131 is coupled to node 103, and the source is coupled to ground. Node 105 is coupled to the drains of device 130 and device 131 and to the gate of p-channel device 132. The source, drain and substrate of p-channel device 132 are coupled to Vccx 7. P-channel device 132 is configured like a capacitor for AC timing to slow the rise of node 105.

Node 105 is coupled to the gate of p-channel device 140 and the gate of n-channel device 141. The source and substrate of device 140 are coupled to Vccx 7, and the source of device 141 is coupled to ground. The drains of device 140 and device 141 are coupled to node 107, and node 107 is coupled to the gate of pchannel device 150 and the gate of n-channel device 151. The source and substrate of device 150 are coupled to Vccx, and the source of device 151 is coupled to ground. The drains of device 150 and device 151 provide the output for LVcc 9.

The gate of p-channel device 142 is coupled to node 107. The source and substrate of device 142 are coupled to Vccx 7, and the drain is coupled to node 105. P-channel device 142 provides a hysteresis effect on output LVcc 9. LVcc 9 becomes active at a different threshold voltage when Vcc is raised to 5 volts than when Vcc is reduced from 5 volts. When Vcc is low, node 105 is high, and node 107 is low which drives device 142 to a highly conducting state. As Vcc increases device 131 competes with both device 142 and device 130 to pull node 105 down, causing a higher trip voltage. As Vcc is reduced from a high state, node 107 begins high which reduces the conductivity of device 142. Thus, device 131 has less load from device 142, causing a lower trip voltage of about 3 volts. Hysteresis is provided, so that when Vcc drops, but remains higher than 3 volts, circuitry on the chip remains operational. P-channel device 142 reduces the trip voltage to less than 3 volts during a power down sequence as opposed to just above 3 volts during a power up sequence. Thus, as Vcc is reduced LVcc 9 becomes inactive at a lower Vcc voltage than when Vcc is increased from 0 volts.

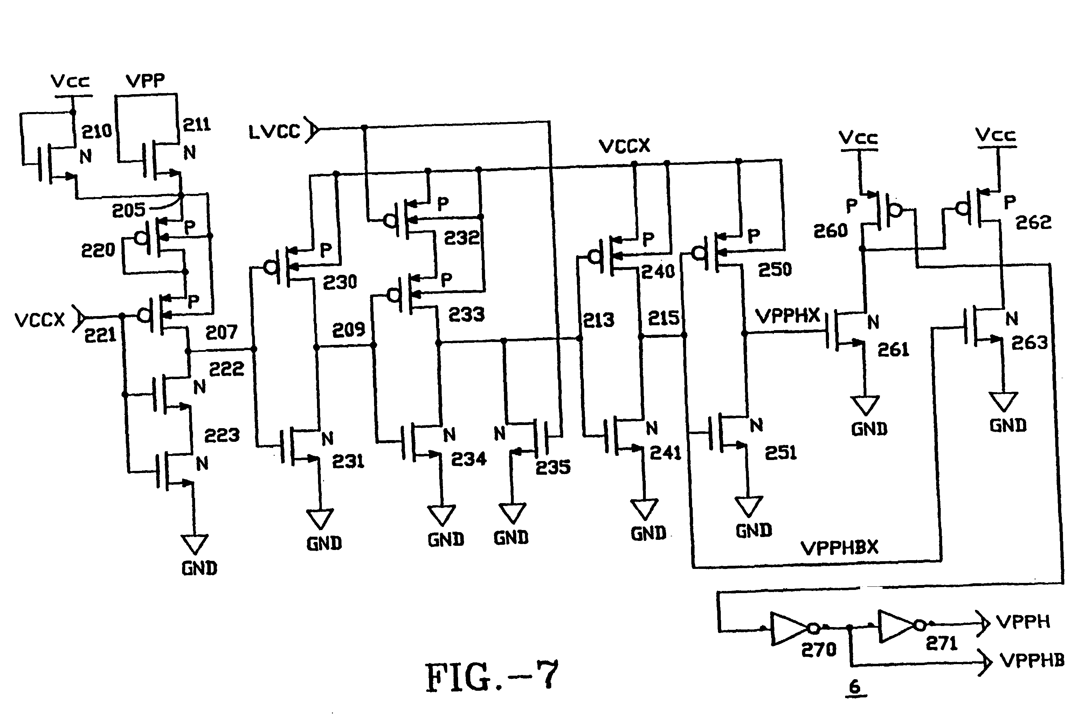

Fig. 7 is a circuit diagram of high Vpp detector 6. The inputs to high Vpp detector 6 are Vccx 7, Vpp, Vcc and LVcc 9. Vccx 7 provides power for high Vpp detector 6. The outputs to high Vpp detector 6 are Vpph 1 and Vpphb 8. Vpphb 8 is the compliment of output Vpph 1. Vpph 1 is low when Vpp does not exceed a predetermined high voltage level or when LVcc 9 is high.

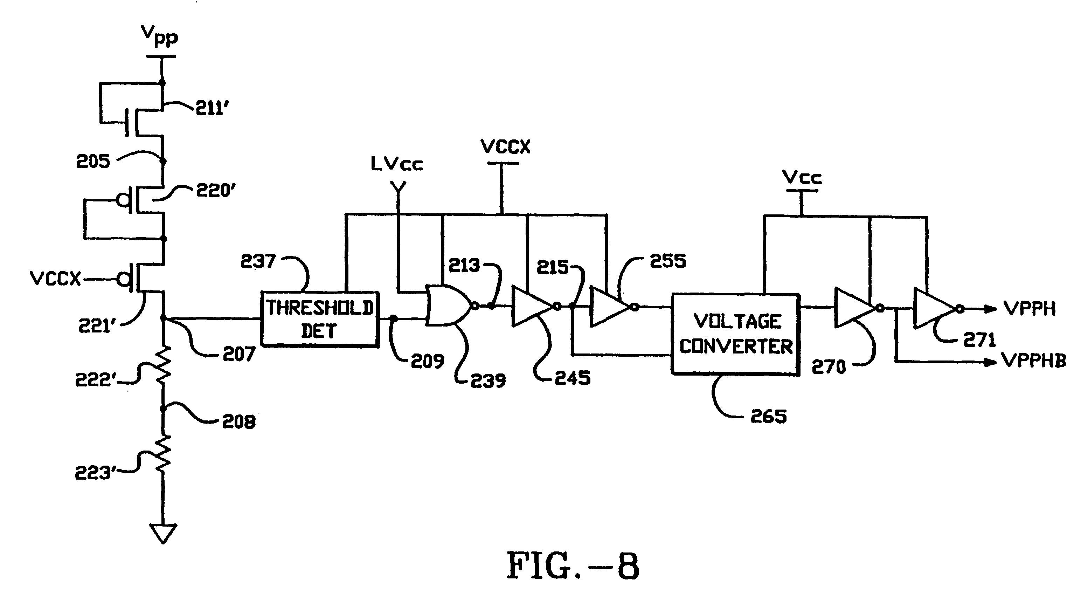

Fig. 8 depicts a simplified diagram of high Vpp detector 6. Vpp is supplied through diode-connected n-channel transistor 211' to node 205, and from node 205 through diode-connected p-channel transistor 220' to the source of p-channel transistor 221'. The gate of p-channel device 221' is coupled to Vccx, and the drain of p-channel device 221' is coupled to node 207. Resistive device 222' is coupled between node 207 and node 208. Resistive device 223' is coupled between node 208 and ground. The input of threshold detector 237 is coupled to node 207, and the output is coupled to node 209. The inputs of NOR gate 239 are coupled to node 209 and LVcc, and the output is coupled to node 213. The input of inverter 245 is coupled to node 213, and the output is coupled to node 215 and an input voltage converter 265. The input of inverter 255 is coupled to node 215, and the output is coupled to a second input of voltage converter 265. Voltage converter 265 translates the signal level from Vccx powered circuits 237, 239, 245, and 255, to normal Vcc levels for circuits 270 and 271 which are powered by Vcc. The output of voltage converter 265 is coupled the input of inverter 270. The output of inverter 270 is Vpphb. The input of inverter 271 is coupled to Vpphb, and the output is Vpph.

Vccx provides an input to the gate of p-channel device 221' to enable the Vpp detector. P-channel device 221' is configured to turn on and allow current to flow when Vpp is approximately 3 volts higher than the input Vccx 7. The Vpp input to p-channel device 221' is reduced by 3 volts by diode devices 211' and 220' and the threshold voltage of p-channel device 221'. N-channel devices 222' and 223' are very resistive. As shown in Table I, the lengths of devices 222 and 223 of Fig. 7 are 6 times longer than the width. P-channel device 230 and n-channel device 231 of Fig. 7 are depicted as threshold detector 237 in Fig. 8. P-channel devices 232 and 233 and n-channel devices 234 and 235 of Fig. 7 are depicted as nor gate 239 in Fig. 8. P-channel device 240 and n-channel device 241 of Fig. 7 are depicted as inverter 245 in Fig. 8. P-channel device 250 and n-channel 251 of Fig. 7 are depicted as inverter 255 in Fig. 8. P-channel devices 260 and 262 and n-channel devices 261 and 263 of Fig. 7 are depicted as voltage converter 265 in Fig. 8. Inverters 270 and 271 of Fig. 7 are also shown in Fig. 8. The use of CMOS devices in high Vpp detector 6 reduces power dissipation.

Referring to Fig. 8, when Vpp is 3 volts greater than Vccx, device 221' is on and current flows from Vcc to ground through resistive devices 222' and 223'. The current flow through resistive devices 222' and 223' provides the voltage to activate threshold detector 237. As shown in Table I, the dimensions of p-channel device 230 differ with n-channel device 231. Threshold detector 237 sets the threshold voltage for high Vpp detector 6. Thus, the threshold voltage for high Vpp detector 6 can be varied according to the dimensions of the devices. Resistive devices 222' and 223' and p-channel device 221' are configured to cause threshold detector 237 to a low logic level when Vpp exceeds the predetermined high voltage. The low logic level from the output of threshold detector 237 is applied to the input of nor gate 239. If LVcc input to nor gate 239 is low, the output of nor gate 239 will depend on the input from threshold detector 237. The low logic level from threshold detector 237 causes nor gate 239 to provide a high logic level. The output of inverter 245 will be a low logic level and the output of inverter 255 will be a high logic level. The high signal, after conversion from Vccx to Vcc level in converter 265, and supply to the input of inverter 270, causes the output of inverter 270 to be a low logic level, providing the signal Vpphb. After the signal flows through inverter 271, Vpph will be a high logic level. Thus, when Vpp is at least 3 volts higher than Vccx and LVcc is low, device 221 is on and Vpph will have a high logic level. Referring to Fig. 7, devices 211, 220, 221, 222 and 223 correspond to devices 211', 220', 221', 222' and 223' of Fig. 8. The gate and drain of n-channel device 211 are coupled to Vpp, and the source of n-channel device 211 is coupled to the source of n-channel device 210, the source and substrate of pchannel device 220, and the substrate of p-channel device 221. The gate and drain of n-channel device 210 are coupled to Vcc. Device 210 supplies voltage to node 205 to prevent the node from floating when Vpp is not active. The drain and gate of p-channel device 220 are coupled to the source of p-channel device 221. Vccx 7 is coupled to the gates of p-channel device 221, n-channel device 222 and n-channel device 223. The drain of device 221 is coupled to the drain of device 222, and the source of device 222 is coupled to the drain of device 223. The source of device 223 is coupled to ground. Devices 211 and 220-223 are configured to supply a trip voltage at node 207.

The trip voltage provides the input to threshold detector 237. Threshold detector 237 is an inverter comprised of p-channel device 230 and n-channel device 231. The source and substrate of p-channel device 230 are coupled to Vccx 7, and the drain is coupled to the drain of n-channel device 231. The input of the inverter is coupled to node 207 which is coupled to the gate of p-channel device 230 and the gate of n-channel device 231. The source of n-channel device 231 is coupled to ground.

Node 209 is the output of threshold detector 237 and is coupled to the gate of p-channel device 233 and the gate of n-channel device 234. Node 209 provides the first input to nor gate 239. The drains of n-channel device 234, n-channel device 235, and p-channel device 233 are coupled together at node 213. The source of n-channel device 235 is coupled to ground, and the gate is coupled to LVcc and the gate of p-channel device 232. LVcc provides the second input to nor gate 239. The source of n-channel device 234 is coupled to ground while the source and substrate of pchannel device 232 and the substrate of p-channel device 233 are coupled to Vccx. The drain of p-channel device 232 is coupled to the source of p-channel device 233. The output of nor gate 239 is node 213.

Node 213 provides the input to inverter 245 at the gates of p-channel device 240 and n-channel device 241. The drains of p-channel device 240 and n-channel device 241 are coupled together and form the output of inverter 245 at node 215. The source and substrate of p-channel device 240 are coupled to Vccx while the source of n-channel device 241 is coupled to ground.

Node 215 provides the input to the gate of pchannel device 250 and the gate of n-channel device 251. Node 215 is also Vpphbx which is an input to converter 265. The drain of p-channel device 250 is coupled to the drain of n-channel device 251 and provides the output Vpphx. The source and substrate of p-channel device 250 are coupled to Vccx while the source of n-channel device 251 is coupled to ground.

Vpphx is coupled to the gate of n-channel device 261 while Vpphbx is coupled to the gate of n-channel device 263. The drain of p-channel device 260 is coupled to the drain of n-channel device 261 while the drain of p-channel device 262 is coupled to the drain of n-channel device 263. The gate of p-channel device 260 is coupled to the drain of p-channel device 262 while the gate of p-channel device 262 is coupled to the drain of p-channel device 260. The sources of p-channel devices 260 and 262 are coupled to Vcc while the sources of n-channel devices 261 and 263 are coupled to ground. Voltage converter 265 comprising devices 260-263 prevents DC current while converting from Vccx to Vcc levels.

The input of inverter 270 is coupled to the drain of p-channel device 262 while the output of inverter 270 provides the output signal Vpphb and provides the input to inverter 271. Whenever Vpp is less than 8.7 volts, Vpph is a low logic level, and Vpphb is a high logic level. The threshold voltage for high Vpp detector 6 is 8.7 volts assuming Vcc is 5 volts. Thus, as Vpp exceeds 8.7 volts with Vcc at 5 volts, Vpph transitions to a high logic level and Vpphb to a low logic level. The output of inverter 271 is Vpph. Inverters 270 and 271 are used to increase the output drive capability of high Vpp detector 6. The outputs of the inverters 270 and 271 are routed to control state machines and high voltage program and erase circuitry to disable write operations when the power supply levels are invalid.

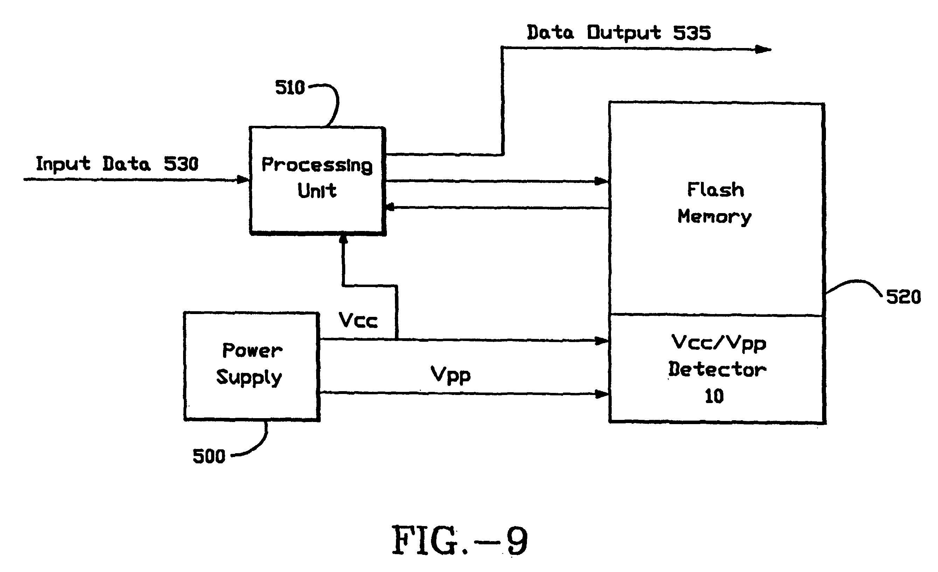

Fig. 9 depicts a system embodiment for Vcc/Vpp detection circuit 10. A processing unit 510 processes input data 530 and accesses memory 520 for program instructions and data. Data output 535 is provided by processing unit 510.

Memory 520 can be programmed or erased by the application of Vpp and Vcc. Vcc powers the logic for reading program instructions and data from memory 520. Thus, power supply 500 supplies Vcc power to processing unit 510 and to memory 520. Power supply 500 also supplies Vpp to memory 520 for programming operations.

On chip Vcc/Vpp detection circuit 10 of memory 520 is coupled to the Vcc output and the Vpp output of power supply 500. Vcc/Vpp detection circuit 10 prevents voltage from Vpp or Vcc from reprogramming or erasing memory 520 during power up sequences, power down sequences, or situations where the supply power is at a reduced capacity. Memory 520 contains state machines (not shown) to receive control signals from a host processor and the signals from Vcc/Vpp detection circuit 10 to control programming or erasing operations of memory 520. For example, if Vcc/Vpp detection circuit 10 detects a low voltage from Vcc and a high voltage from Vpp, signals from Vcc/Vpp detection circuit 10 will inhibit the programming or erasing mode of memory 520 to prevent inadvertent corruption of the data stored even if a correct command sequence is issued from the host. The state machines may cause memory 520 to be in a read only mode until sufficient Vcc power from power supply 500 is supplied to memory 520.

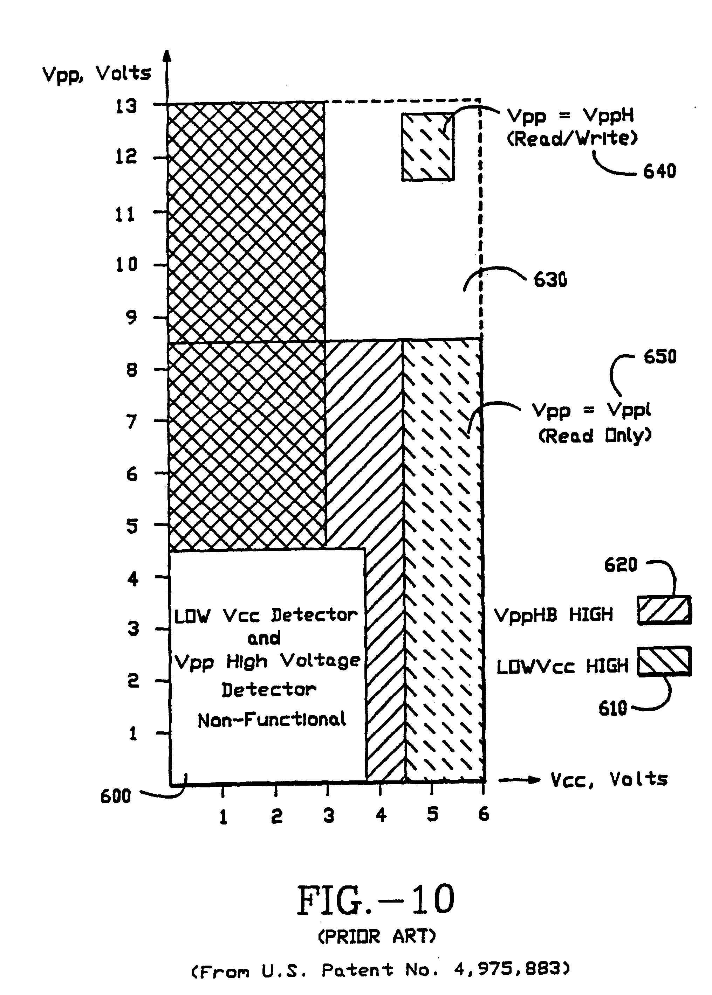

Fig. 10 is a diagram illustrating the operating range of Vcc/Vpp detection circuit 10 for preventing erasure of programming used in the preferred embodiment of the present invention adapted from U.S. Patent No. 4,975,883. The X axis of the diagram in Fig. 19 corresponds to the reading voltage Vcc and the Y axis corresponds to the programming voltage Vpp. Region 600 represents the area where both Vcc and Vpp are sufficiently low that corruption of nonvolatile data cannot occur. This region provides voltages that are too low for most circuits to operate. Even Vcc/Vpp detection circuit 10 does not function. Region 610 represents the area where Vcc is low and the signal LVcc 9 is provided to prevent corruption of the nonvolatile data. Region 620 represents the area where Vpp is low, and the signal Vpph is a low logic level to prevent corruption of the nonvolatile data.

Region 650 represents the area where Vpp is low while Vcc is at the proper operating voltage. Thus, memory 520 can be placed in a read only mode. Region 630 is the area where a user must assure that no spurious writes occur to memory 520. The voltages are sufficient to properly control and operate memory 520. Region 640 is the valid operating range for updating the contents of memory 520.

As shown in Fig. 10, any power up or power down sequence is not possible without passing through the protected regions designated by region 610 and region 620. Thus, the present invention affords nonvolatile memory devices greater protection against spurious system level signals during the power up and power down transitions.

While the present invention has been particularly described with references to Figs. 1-10, and with emphasis on integrated circuits, it should be understood that the figures are for illustration only and should not be taken as limitations on the invention. In addition, it is clear that the method and apparatus of the present invention have utility in many applications where protection against spurious system level signals during power up and power down transitions of a nonvolatile memory device as required. It is contemplated that many changes and modifications may be made by one of ordinary skill in the art without departing from the scope of the invention as defined by the appended claims.

## Claims

1. A voltage detector for monitoring power supply voltages during power up and power down sequences, comprising:
a reference circuit (2) having a first voltage (Vcc) on a first input (3) and a second voltage (Vpp) on a second input (5) and circuitry to reduce the second voltage (Vpp) to a node voltage and to supply a reference voltage (Vccx) in response to a greater one of the first voltage (Vcc) or the node voltage;
a first voltage detection circuit (4) powered by the reference voltage (Vccx) and responsive to the first voltage (Vcc) to provide a first signal (LVcc) when the first voltage (Vcc) is below a first predetermined voltage; ***characterised by***
a second voltage detection circuit (6) powered by the reference voltage (Vccx) and responsive to the second voltage (Vpp) and the first signal (LVcc) to provide a second signal (Vpph), dependant on both the second voltage (Vpp) and the first signal (LVcc).

2. The voltage detector of claim 1, including a voltage divider (24, 25, 30) to reduce the second voltage (Vpp) to the node voltage.

3. The voltage detector of claim 2, wherein the voltage divider comprises MOS devices.

4. The voltage detector of claim 1, wherein the first voltage detection circuit (4) includes a threshold detector set at the first predetermined voltage to provide the first signal (LVcc) when the first voltage (Vcc) is below the first predetermined voltage.

5. The voltage detector of claim 4, wherein the first voltage detection circuit (4) includes a hysteresis circuit, coupled to the threshold detector, to provide the first signal (LVcc) at a third predetermined voltage when the first voltage (Vcc) falls below the third predetermined voltage.

6. The voltage detector of claim 1, wherein the second voltage detection circuit (6) has a first input (3), coupled to the first signal (LVcc) of the first voltage detection circuit (4), and a second input (5), coupled to the second voltage (Vpp), and is responsive to the first signal (LVcc) and the second voltage (Vpp) to provide the second signal (Vpph).

7. The voltage detector of claim 6, wherein the second voltage detection circuit (6) includes:
a diode device (211, 220), coupled to the second voltage (Vpp), to reduce the second voltage (Vpp) to a third voltage;
a control circuit (221¹), coupled to the third voltage and the reference voltage (Vccx), to provide an input voltage when the third voltage is greater than the reference voltage (Vccx); and
a threshold circuit (237), coupled to the control circuit, responsive to the input voltage to provide a threshold signal.

8. The voltage detector of claim 7, wherein the second voltage detection circuit (6) includes an output converter (265), coupled to the threshold circuit, responsive to the threshold signal and the first signal (LVcc) to provide the second signal (Vpph).

9. The voltage detector of claim 1 wherein:
said first input (3) comprises a high voltage input to receive a high supply voltage for use in high voltage operations;
said second input comprises a low voltage input to receive a low supply voltage for use in low voltage operations and high voltage operations;
said first voltage detection circuit (4) comprises a low voltage detector, coupled to the low voltage input and the reference voltage (Vccx), and providing a low voltage detector output, the low voltage detector having circuitry to provide a first not-ready signal at the low voltage detector output when a voltage on the low voltage input falls below a predetermined low voltage threshold and a first ready signal at the low voltage detector output when the voltage on the low voltage input is above a predetermined low voltage threshold; and
said second voltage detection circuit (6). comprises a high voltage detector, coupled to the high voltage input, the reference voltage (Vccx), and the low voltage detector output, and providing a high voltage detector output, the high voltage detector having circuitry to provide a second ready signal at the high voltage detector output in response to the first ready signal and a voltage on the high voltage input which is above a predetermined high voltage threshold, and a second not-ready signal at the high voltage detector output otherwise, so that the second ready signal is not asserted unless both the high supply voltage and the low supply voltage exceed the respective predetermined high voltage threshold and the predetermined low voltage threshold, respectively.

10. The voltage detector of claim 9, wherein the high voltage detector includes a gate circuit responsive to the reference voltage (Vccx) to enable the circuitry to provide the second not-ready signal.

11. The voltage detector of claim 9, wherein the reference circuit (2) comprises:
a node voltage circuit coupled to the high voltage input, the node voltage circuit having an output node to reduce the high supply voltage to a node voltage for the output node; and
a selector circuit that supplies the reference voltage (Vccx) as a function of the greater of the node voltage or the low supply voltage.

12. The voltage detector of claim 11, wherein the node voltage circuit includes active devices.

13. The voltage detector of claim 9, wherein the low voltage detector includes a threshold inverter having a trip voltage set to the predetermined low voltage threshold.

14. The voltage detector of claim 13, wherein the threshold inverter of the low voltage detector includes a transistor device having a channel with a length and a width to set the trip voltage for the threshold inverter of the low voltage detector.

15. The voltage detector of claim 13, wherein the low voltage detector includes a hysteresis circuit, coupled to the threshold inverter, to provide a first predetermined voltage threshold when the low voltage input exceeds the first voltage threshold and a second predetermined voltage threshold when the low voltage input falls below the second voltage threshold.

16. The voltage detector of claim 15, wherein the low voltage detector includes an output buffer, coupled to the hysteresis circuit, to provide the first not-ready signal.

17. The voltage detector of claim 13, wherein the high voltage detector includes a threshold inverter having a trip voltage set to the predetermined high voltage threshold.

18. The voltage detector of claim 17, wherein the threshold inverter of the high voltage detector includes a transistor device having a channel with a length and a width to set the trip voltage for the threshold inverter of the high voltage detector.

19. The voltage detector of claim 17, wherein the high voltage detector includes threshold logic, coupled to the threshold inverter and the first not-ready signal, to provide a threshold signal in response to the threshold inverter and the first not-ready signal.

20. The voltage detector of claim 19, wherein the high voltage detector includes an output buffer responsive to the threshold signal to provide the second not-ready signal.

21. A processing system comprising the voltage detector of claim 1 including:
a power supply to generate a first output for said first voltage (Vcc) comprising a programming voltage and a second output for said second voltage (Vpp) comprising a read voltage;
a memory (520), coupled to the power supply, the first voltage detection circuit, and the second voltage detection circuit, which stores data and program instructions and has circuitry responsive to the first and second signals (LVcc,Vpph) to control access of the memory so that memory cannot be altered when either the second voltage detector detects the first signal (LVcc) or the programming voltage falls below the second predetermined voltage threshold; and
a processing unit (510), coupled to the power supply and to the memory, which accesses data and program instructions in the memory to process the data and the program instructions.

22. The processing system of claim 21, wherein the reference supply includes a voltage reduction circuit, coupled to the programming voltage of the power supply, which provides an intermediate voltage in response to the programing voltage.

23. The processing system of claim 22, wherein the reference supply provides the reference voltage in response to a greater one of the intermediate voltage or the read voltage.

24. The processing system of claim 21, wherein the memory includes a nonvolatile memory that can be erased and programmed when the programing voltage is provided to the memory.

25. The processing system of claim 24, wherein the nonvolatile memory can be placed into a read only mode in response to the first signal.

26. The processing system of claim 24, wherein the second signal disables erase and programming functions to the memory.

27. An integrated circuit memory device comprising:
a memory having a plurality of programmable storage locations; a low voltage input to receive a control supply voltage;
a high voltage input to receive a programming supply voltage;
a reference circuit (2), coupled to the high voltage input and the low voltage input, having a divider circuit to reduce the programming supply voltage to a node voltage and to supply a reference voltage at a reference circuit output in response to a greater one of the control voltage or the node voltage;
a control supply voltage detection circuit, powered by the reference circuit output, and providing a control supply output, the control supply voltage detection circuit responsive to the control supply voltage to provide a control supply signal at the control supply output which indicates whether the control supply voltage is above or below a predetermined minimum control supply voltage; and
a programming supply voltage detection circuit, powered by the reference circuit output and the control supply output, and providing a programming supply output, the programming supply voltage detection circuit responsive to the programming supply voltage and the control supply signal to provide a programming supply signal at the programming supply output with one indication when the programming supply voltage is above a predetermined minimum programming supply voltage and the control supply voltage is above the predetermined minimum control supply voltage, and another indication otherwise.

28. The integrated circuit memory device of claim 27, wherein the divider circuit includes active devices to reduce the programming supply voltage to the node voltage.

29. The integrated circuit memory device of claim 27, wherein the programming supply voltage detection circuit includes a gate circuit responsive to the reference voltage to enable the programming supply voltage detection circuit when the reference voltage falls within a predetermined range below the programming supply voltage.

30. The integrated circuit memory device of claim 27, wherein the control supply voltage detection circuit includes a threshold detector having a voltage threshold set at the predetermined minimum control supply voltage to provide a threshold output.

31. The integrated circuit memory device of claim 30, wherein the threshold detector includes an inverter having a trip voltage set at the voltage threshold.

32. The integrated circuit memory device of claim 31, wherein the inverter includes a p-channel device and a n-channel device having a channel with a length and a width set to the trip voltage.

33. The integrated circuit memory device of claim 30, wherein the control supply voltage detection circuit includes hysteresis circuitry to provide a first minimum control supply voltage threshold during a rising supply voltage sequence and a second minimum control supply voltage threshold during a falling supply sequence.

34. The integrated circuit memory device of claim 33, wherein the control supply voltage detection circuit includes an output circuitry, coupled to the hysteresis circuitry to provide the low control supply signal.

35. The integrated circuit memory device of claim 27, wherein the programming supply voltage detection circuit includes circuitry having active devices to reduce the programming supply voltage to a reduced voltage and to provide a detection voltage when the reduced voltage is greater than the reference voltage.

36. The integrated circuit memory device of claim 35, wherein the programming supply voltage detection circuit includes a threshold detector having a voltage threshold set at the predetermined minimum programming supply voltage to provide a threshold output in response to the detector voltage.

37. The integrated circuit memory device of claim 36, wherein the threshold detector includes an inverter having the voltage threshold set at the predetermined minimum programming supply voltage.

38. The integrated circuit memory device of claim 36, wherein the programming supply voltage detection circuit includes logic which receives inputs from the low control supply signal of the control supply voltage detection circuit and the threshold signal to provide a logic signal.

39. The integrated circuit memory device of claim 38, wherein the programming voltage detection circuit includes an output buffer coupled to the logic responsive to the logic signal to provide the low programming signal.

## Patentansprüche

1. Spannungsdetektor zum Überwachen von Stromversorgungsspannungen während Einschalt- und Ausschaltabläufen, umfassend:
eine Referenzschaltung (2) mit einer ersten Spannung (Vcc) an einem ersten Eingang (3) und einer zweiten Spannung (Vpp) an einem zweiten Eingang (5) und einer Schaltungsanordnung zum Reduzieren der zweiten Spannung (Vpp) auf eine Knotenspannung und zum Liefern einer Referenzspannung (Vccx) in Reaktion auf eine größere Spannung der ersten Spannung (Vcc) und der Knotenspannung;
eine erste Spannungsdetektionsschaltung (4), die durch die Referenzspannung (Vccx) versorgt wird und auf die erste Spannung (Vcc) anspricht, um ein erstes Signal (LVcc) bereitzustellen, wenn die erste Spannung (Vcc) unter einer ersten vorbestimmten Spannung ist; **gekennzeichnet durch**
eine zweite Spannungsdetektionsschaltung (6), die **durch** die Referenzspannung (Vccx) versorgt wird und auf die zweite Spannung (Vpp) und das erste Signal (LVcc) anspricht, um ein zweites Signal (Vpph) bereitzustellen, abhängig sowohl von der zweiten Spannung (Vpp) als auch dem ersten Signal (LVcc).

2. Spannungsdetektor nach Anspruch 1, umfassend einen Spannungsteiler (24, 25, 30) zum Reduzieren der zweiten Spannung (Vpp) auf die Knotenspannung.

3. Spannungsdetektor nach Anspruch 2, wobei der Spannungsteiler MOS-Bauelemente umfaßt.

4. Spannungsdetektor nach Anspruch 1, wobei die erste Spannungsdetektionsschaltung (4) einen Schwellendetektor umfaßt, der auf eine erste vorbestimmte Spannung eingestellt ist, um das erste Signal (LVcc) bereitzustellen, wenn die erste Spannung (Vcc) unter der ersten vorbestimmten Spannung ist.

5. Spannungsdetektor nach Anspruch 4, wobei die erste Spannungsdetektionsschaltung (4), gekoppelt an den Schwellendetektor, eine Hystereseschaltung umfaßt, um das erste Signal (LVcc) bei einer dritten vorbestimmten Spannung bereitzustellen, wenn die erste Spannung (Vcc) unter die dritte vorbestimmte Spannung fällt.

6. Spannungsdetektor nach Anspruch 1, wobei die zweite Spannungsdetektionsschaltung (6), gekoppelt an das erste Signal (LVcc) der ersten Spannungsdetektionsschaltung (4), einen ersten Eingang (3) aufweist und, gekoppelt mit der zweiten Spannung (Vpp), einen zweiten Eingang (5) aufweist und auf das erste Signal (LVcc) und die zweite Spannung (Vpp) anspricht, um das zweite Signal (Vpph) bereitzustellen.

7. Spannungsdetektor nach Anspruch 6, wobei die zweite Spannungsdetektionsschaltung (6) umfaßt:
gekoppelt mit der zweiten Spannung (Vpp), eine Diodeneinrichtung (211, 220), um die zweite Spannung (Vpp) auf eine dritte Spannung zu reduzieren;
gekoppelt mit der dritten Spannung und der Referenzspannung (Vccx), eine Steuerschaltung (221¹), um eine Eingangsspannung bereitzustellen, wenn die dritte Spannung größer als die Referenzspannung (Vccx) ist; und
gekoppelt mit der Steuerschaltung, eine Schwellenschaltung (237), die auf die Eingangsspannung anspricht, um ein Schwellensignal bereitzustellen.

8. Spannungsdetektor nach Anspruch 7, wobei die zweite Spannungsdetektionsschaltung (6), gekoppelt mit der Schwellenschaltung, einen Ausgangswandler (265) umfaßt, der auf das Schwellensignal und das erste Signal (LVcc) anspricht, um das zweite Signal (Vpph) bereitzustellen.

9. Spannungsdetektor nach Anspruch 1, wobei:
der erste Eingang (3) einen Eingang für hohe Spannung umfaßt, um eine hohe Versorgungsspannung zur Verwendung bei Vorgängen mit hoher Spannung zu empfangen;
der zweite Eingang einen Eingang für niedrige Spannung umfaßt, um eine niedrige Versorgungsspannung zur Verwendung bei Vorgängen mit niedriger Spannung und Vorgängen mit hoher Spannung zu empfangen;
die erste Spannungsdetektionsschaltung (4) einen Detektor für niedrige Spannung umfaßt, der mit dem Eingang für niedrige Spannung und der Referenzspannung (Vccx) gekoppelt ist und eine Detektorausgabe für eine niedrige Spannung bereitstellt, wobei der Detektor für niedrige Spannung eine Schaltungsanordnung aufweist, um ein erstes Nicht-Bereitschaft-Signal an dem Detektorausgang für niedrige Spannung bereitzustellen, wenn eine Spannung an dem Eingang für niedrige Spannung unter eine vorbestimmte Schwelle für niedrige Spannung fällt, und ein erstes Bereitschaft-Signal an dem Detektorausgang für niedrige Spannung bereitzustellen, wenn die Spannung an dem Eingang für niedrige Spannung über einer vorbestimmten Schwelle für niedrige Spannung ist; und
die zweite Spannungsdetektionsschaltung (6) einen Detektor für hohe Spannung umfaßt, der mit dem Eingang für hohe Spannung, der Referenzspannung (Vccx) und dem Detektorausgang für niedrige Spannung gekoppelt ist und eine Detektorausgabe für hohe Spannung bereitstellt, wobei der Detektor für hohe Spannung eine Schaltungsanordnung aufweist, um ein zweites Bereitschaft-Signal an dem Detektorausgang für hohe Spannung in Reaktion auf das erste Bereitschaft-Signal und eine Spannung an dem Eingang für hohe Spannung bereitzustellen, welche über einer vorbestimmten Schwelle für hohe Spannung ist, und andernfalls ein zweites Nicht-Bereitschaft-Signal an dem Detektorausgang für hohe Spannung bereitzustellen, so daß das zweite Bereitschaft-Signal nicht geltend gemacht wird, sofern nicht die hohe Versorgungsspannung als auch die niedrige Versorgungsspannung die vorbestimmte Schwelle für hohe Spannung bzw. die vorbestimmte Schwelle für niedrige Spannung übersteigt.

10. Spannungsdetektor nach Anspruch 9, wobei der Detektor für hohe Spannung eine auf die Referenzspannung (Vccx) ansprechende Gatterschaltung umfaßt, um der Schaltungsanordnung zu ermöglichen, das zweite Nicht-Bereitschaft-Signal bereitzustellen.

11. Spannungsdetektor nach Anspruch 9, wobei die Referenzschaltung (2) umfaßt:
eine mit dem Eingang für hohe Spannung gekoppelte Knotenspannungsschaltung, wobei die Knotenschaltungsspannung einen Ausgangsknoten aufweist, um die hohe Versorgungsspannung auf eine Knotenspannung für den Ausgangsknoten zu reduzieren; und
eine Wahlschaltung, welche die Referenzspannung (Vccx) als eine Funktion der größeren Spannung der Knotenspannung und der niedrigen Versorgungsspannung liefert.

12. Spannungsdetektor nach Anspruch 11, wobei die Knotenspannungsschaltung aktive Bauelemente umfaßt.

13. Spannungsdetektor nach Anspruch 9, wobei der Detektor für niedrige Spannung einen Schwelleninverter mit einer Triggerspannung umfaßt, die auf die vorbestimmte Schwelle für niedrige Spannung eingestellt ist.

14. Spannungsdetektor nach Anspruch 13, wobei der Schwelleninverter des Detektors für niedrige Spannung ein Transistorbauelement umfaßt, welches einen Kanal mit einer Länge und einer Breite aufweist, um die Triggerspannung für den Schwelleninverter des Detektors für niedrige Spannung einzustellen.

15. Spannungsdetektor nach Anspruch 13, wobei der Detektor für niedrige Spannung, gekoppelt mit dem Schwelleninverter, eine Hystereseschaltung umfaßt, um eine erste vorbestimmte Spannungsschwelle bereitzustellen, wenn die Eingabe für niedrige Spannung die erste Spannungsschwelle übersteigt, und eine zweite vorbestimmte Spannungsschwelle bereitzustellen, wenn die Eingabe für niedrige Spannung unter die zweite Spannungsschwelle fällt.

16. Spannungsdetektor nach Anspruch 15, wobei der Detektor für niedrige Spannung, gekoppelt mit der Hystereseschaltung, einen Ausgangspuffer umfaßt, um das erste Nicht-Bereitschaft-Signal bereitzustellen.

17. Spannungsdetektor nach Anspruch 13, wobei der Detektor für hohe Spannung einen Schwelleninverter mit einer Triggerspannung umfaßt, die auf die vorbestimmte Schwelle für hohe Spannung eingestellt ist.

18. Spannungsdetektor nach Anspruch 17, wobei der Schwelleninverter des Detektors für hohe Spannung ein Transistorbauelement umfaßt, welches einen Kanal mit einer Länge und einer Breite aufweist, um die Triggerspannung für den Schwelleninverter des Detektors für hohe Spannung einzustellen.

19. Spannungsdetektor nach Anspruch 17, wobei der Detektor für hohe Spannung, gekoppelt mit dem Schwelleninverter und dem ersten Nicht-Bereitschaft-Signal, eine Schwellenlogik umfaßt, um ein Schwellensignal in Reaktion auf den Schwelleninverter und das erste Nicht-Bereitschaft-Signal bereitzustellen.

20. Spannungsdetektor nach Anspruch 19, wobei der Detektor für hohe Spannung einen Ausgangspuffer umfaßt, der auf das Schwellensignal anspricht, um das zweite Nicht-Bereitschaft-Signal bereitzustellen.

21. Verarbeitungssystem, umfassend den Spannungsdetektor nach Anspruch 1, umfassend:
eine Stromversorgung zum Erzeugen einer ersten Ausgabe für die erste Spannung (Vcc) umfassend eine Programmierspannung und einer zweiten Ausgabe für die zweite Spannung (Vpp) umfassend eine Lesespannung;
gekoppelt mit der Stromversorgung, der ersten Spannungsdetektionsschaltung und der zweiten Spannungsdetektionsschaltung, einen Speicher (520), der Daten und Programmanweisungen speichert und eine Schaltungsanordnung aufweist, die auf das erste und das zweite Signal (LVcc, Vpph) anspricht, um einen Zugriff auf den Speicher derart zu steuern, daß der Speicher nicht verändert werden kann, wenn entweder der zweite Spannungsdetektor das erste Signal (LVcc) detektiert oder die Programmierspannung unter die zweite vorbestimmte Spannungsschwelle fällt; und
gekoppelt mit der Stromversorgung und dem Speicher, eine Verarbeitungseinheit (510), die auf Daten und Programmanweisungen in dem Speicher zugreift, um die Daten und die Programmanweisungen zu verarbeiten.

22. Verarbeitungssystem nach Anspruch 21, wobei die Referenzversorgung, gekoppelt mit der Programmierspannung der Stromversorgung, eine Spannungsreduzierungsschaltung umfaßt, welche eine Zwischenspannung in Reaktion auf die Programmierspannung bereitstellt.

23. Verarbeitungssystem nach Anspruch 22, wobei die Referenzversorgung die Referenzspannung in Reaktion auf eine größere Spannung der Zwischenspannung und der Lesespannung bereitstellt.

24. Verarbeitungssystem nach Anspruch 21, wobei der Speicher einen nichtflüchtigen Speicher umfaßt, der gelöscht oder programmiert werden kann, wenn die Programmierspannung dem Speicher bereitgestellt wird.

25. Verarbeitungssystem nach Anspruch 24, wobei der nichtflüchtige Speicher in einen Nur-Lese-Modus in Reaktion auf das erste Signal versetzt werden kann.

26. Verarbeitungssystem nach Anspruch 24, wobei das zweite Signal Lösch- und Programmierfunktionen für den Speicher verbietet.

27. Speichereinrichtung einer integrierten Schaltung, umfassend:
einen Speicher mit einer Mehrzahl von programmierbaren Speicherstellen; einen Eingang für niedrige Spannung zum Empfangen einer Steuerversorgungsspannung;
einen Eingang für hohe Spannung zum Empfangen einer Programmierversorgungsspannung;
gekoppelt mit dem Eingang für hohe Spannung und dem Eingang für niedrige Spannung, eine Referenzschaltung (2) mit einer Teilerschaltung, um die Programmierversorgungsspannung auf eine Knotenspannung zu reduzieren und eine Referenzspannung an einem Referenzschaltungsausgang in Reaktion auf eine größere Spannung der Steuerspannung und der Knotenspannung zu liefern;
eine Detektionsschaltung für die Steuerversorgungsspannung, die durch die Referenzschaltungsausgabe versorgt wird und eine Steuerversorgungsausgabe bereitstellt, wobei die Detektionsschaltung für die Steuerversorgungsspannung auf die Steuerversorgungsspannung anspricht, um ein Steuerversorgungssignal an dem Steuerversorgungsausgang bereitzustellen, welches angibt, ob die Steuerversorgungsspannung über oder unter einer vorbestimmten Minimum-Steuerversorgungsspannung ist; und
eine Detektionsschaltung für die Programmierversorgungsspannung, die durch die Referenzschaltungsausgabe und die Steuerversorgungsausgabe versorgt wird und eine Programmierversorgungsausgabe bereitstellt, wobei die Detektionsschaltung für die Programmierversorgungsspannung auf die Programmierversorgungsspannung und das Steuerversorgungssignal anspricht, um ein Programmierversorgungssignal an dem Programmierversorgungsausgang mit einer Angabe bereitzustellen, wenn die Programmierversorgungsspannung über einer vorbestimmten Minimum-Programmierversorgungsspannung ist und die Steuerversorgungsspannung über der vorbestimmten Minimum-Steuerversorgungsspannung ist, und
andernfalls mit einer anderen Angabe bereitzustellen.

28. Speichereinrichtung einer integrierten Schaltung nach Anspruch 27, wobei die Teilerschaltung aktive Bauelemente umfaßt, um die Programmierversorgungsspannung auf die Knotenspannung zu reduzieren.

29. Speichereinrichtung einer integrierten Schaltung nach Anspruch 27, wobei die Detektionsschaltung für die Programmierversorgungsspannung eine Gatterschaltung umfaßt, die auf die Referenzspannung anspricht, um die Detektionsschaltung für die Programmierversorgungsspannung freizugeben, wenn die Referenzspannung in einen vorbestimmten Bereich unter der Programmierversorgungsspannung fällt.

30. Speichereinrichtung einer integrierten Schaltung nach Anspruch 27, wobei die Detektionsschaltung für die Steuerversorgungsspannung einen Schwellendetektor mit einer Spannungsschwelle umfaßt, die auf die vorbestimmte Minimum-Steuerversorgungsspannung eingestellt ist, um eine Schwellenausgabe bereitzustellen.

31. Speichereinrichtung einer integrierten Schaltung nach Anspruch 30, wobei der Schwellendetektor einen Inverter mit einer Triggerspannung umfaßt, die auf die Spannungsschwelle eingestellt ist.

32. Speichereinrichtung einer integrierten Schaltung nach Anspruch 31, wobei der Inverter ein p-Kanal-Bauelement und ein n-Kanal-Bauelement mit einem Kanal mit einer Länge und einer Breite umfaßt, der für die Triggerspannung eingestellt ist.

33. Speichereinrichtung einer integrierten Schaltung nach Anspruch 30, wobei die Detektionsschaltung für die Steuerversorgungsspannung eine Hystereseschaltungsanordnung umfaßt, um eine erste Minimum-Steuerversorgungsspannung-Schwelle während eines Ablaufs mit ansteigender Versorgungsspannung und eine zweite Minimum-Steuerversorgungsspannung-Schwelle während eines Ablaufs mit fallender Versorgung bereitzustellen.

34. Speichereinrichtung einer integrierten Schaltung nach Anspruch 33, wobei die Detektionsschaltung für die Steuerversorgungsspannung, gekoppelt mit der Hystereseschaltungsanordnung, eine Ausgangsschaltungsanordnung umfaßt, um das Niedrig-Steuerversorgungssignal bereitzustellen.

35. Speichereinrichtung einer integrierten Schaltung nach Anspruch 27, wobei die Detektionsschaltung für die Programmierversorgungsspannung eine Schaltungsanordnung mit aktiven Bauelementen umfaßt, um die Programmierversorgungsspannung auf eine reduzierte Spannung zu reduzieren und eine Detektionsspannung bereitzustellen, wenn die reduzierte Spannung größer als die Referenzspannung ist.

36. Speichereinrichtung einer integrierten Schaltung nach Anspruch 35, wobei die Detektionsschaltung für die Programmierversorgungsspannung einen Schwellendetektor mit einer Spannungsschwelle umfaßt, die auf die vorbestimmte Minimum-Programmierversorgungsspannung eingestellt ist, um eine Schwellenausgabe in Reaktion auf die Detektorspannung bereitzustellen.

37. Speichereinrichtung einer integrierten Schaltung nach Anspruch 36, wobei der Schwellendetektor einen Inverter umfaßt, der die Spannungsschwelle auf die vorbestimmte Minimum-Prögrammierversorgungsspannung eingestellt aufweist.

38. Speichereinrichtung einer integrierten Schaltung nach Anspruch 36, wobei die Detektionsschaltung für die Programmierversorgungsspannung eine Logik umfaßt, die Eingaben von dem Niedrig-Steuerversorgungssignal der Detektionsschaltung für die Steuerversorgungsspannung sowie des Schwellensignals empfängt, um ein Logiksignal bereitzustellen.

39. Speichereinrichtung einer integrierten Schaltung nach Anspruch 38, wobei die Detektionsschaltung für die Programmierspannung einen Ausgangspuffer mit der Logik gekoppelt umfaßt, der auf das Logiksignal anspricht, um das Niedrig-Programmiersignal bereitzustellen.

## Revendications

1. Détecteur de tension destiné à surveiller des tensions d'alimentation durant les séquences de mise sous tension et de mise hors tension, comprenant :
un circuit de référence (2) présentant une première tension (Vcc) sur une première entrée (3) et une seconde tension (Vpp) sur une seconde entrée (5) et un circuit destiné à réduire la seconde tension (Vpp) à une tension de noeud et à fournir une tension de référence (Vccx) en réponse à la plus grande de la première tension (Vcc) ou de la tension de noeud ;
un premier circuit de détection de tension (4) alimenté par la tension de référence (Vccx) et sensible à la première tension (Vcc) pour fournir un premier signal (LVcc) lorsque la première tension (Vcc) est en dessous d'une première tension prédéterminée ; ***caractérisé par***
un second circuit de détection de tension (6) alimenté par la tension de référence (Vccx) et sensible à la seconde tension (Vpp) et au premier signal (LVcc) pour fournir un second signal (Vpph) suivant à la fois la seconde tension (Vpp) et le premier signal (LVcc).

2. Détecteur de tension selon la revendication 1, comprenant un diviseur de tension (24, 25, 30) destiné à réduire la seconde tension (Vpp) à la tension de noeud.

3. Détecteur de tension selon la revendication 2, dans lequel le diviseur de tension comprend des dispositifs de type MOS (métal-oxyde-semiconducteur) .

4. Détecteur de tension selon la revendication 1, dans lequel le premier circuit de détection de tension (4) comprend un détecteur de seuil réglé à la première tension prédéterminée pour fournir le premier signal (LVcc) lorsque la première tension (Vcc) est en dessous de la première tension prédéterminée.

5. Détecteur de tension selon la revendication 4, dans lequel le premier circuit de détection de tension (4) comprend un circuit à hystérésis, relié au détecteur de seuil, afin de fournir le premier signal (LVcc) à une troisième tension prédéterminée lorsque la première tension (Vcc) chute en dessous de la troisième tension prédéterminée.

6. Détecteur de tension selon la revendication 1, dans lequel le second circuit de détection de tension (6) comporte une première entrée (3), reliée au premier signal (LVcc) du premier circuit de détection de tension (4), et une seconde entrée (5), reliée à la seconde tension (Vpp), et est sensible au premier signal (LVcc) et à la seconde tension (Vpp) afin de fournir le second signal (Vpph).

7. Détecteur de tension selon la revendication 6, dans lequel le second circuit de détection de tension (6) comprend :
un dispositif de type diode (211, 220) relié à la seconde tension (Vpp), afin de réduire la seconde tension (Vpp) à une troisième tension ;
un circuit de commande (221'), relié à la troisième tension et à la tension de référence (Vccx), afin de fournir une tension d'entrée lorsque la troisième tension est supérieure à la tension de référence (Vccx), et
un circuit de seuil (237), relié au circuit de commande, sensible à la tension d'entrée pour fournir un signal de seuil.

8. Détecteur de tension selon la revendication 7, dans lequel le second circuit de détection de tension (6) comprend un convertisseur de sortie (265), relié au circuit de seuil, sensible au signal de seuil et au premier signal (LVcc) afin de fournir le second signal (Vpph).

9. Détecteur de tension selon la revendication 1, dans lequel :
ladite première entrée (3) comprend une entrée de tension élevée destinée à recevoir une tension d'alimentation élevée en vue d'une utilisation dans des opérations à tension élevée ;
ladite seconde entrée comprend une entrée à basse tension destinée à recevoir une alimentation à basse tension destinée à être utilisée dans les opérations à basse tension et les opérations à tension élevée ;
ledit premier circuit de détection de tension (4) comprend un détecteur de basse tension, relié à l'entrée de basse tension et à la tension de référence (Vccx), et fournissant une sortie de détecteur de basse tension, le détecteur de basse tension comportant un circuit destiné à fournir un premier signal d'état non prêt à la sortie du détecteur de basse tension lorsqu'une tension sur l'entrée de basse tension chute en dessous d'un seuil de basse tension prédéterminé, et un premier signal d'état prêt à la sortie du détecteur de basse tension lorsque la tension sur l'entrée de basse tension est au-dessus d'un seuil de basse tension prédéterminé ; et
ledit second circuit de détection de tension (6) comprend un détecteur de tension élevée, relié à l'entrée de tension élevée, à la tension de référence (Vccx), et à la sortie du détecteur de basse tension, et fournissant une sortie du détecteur de tension élevée, le détecteur de tension élevée comportant un circuit destiné à fournir un second signal d'état prêt à la sortie du détecteur de tension élevée en réponse au premier signal d'état prêt et une tension sur l'entrée de tension élevée qui est au-dessus d'un seuil de tension élevée prédéterminé, et sinon un second signal d'état non prêt à la sortie du détecteur de tension élevée, de sorte que le second signal d'état prêt n'est pas confirmé sauf si à la fois la tension d'alimentation élevée et la tension d'alimentation basse dépassent le seuil de tension élevée prédéterminé et le seuil de tension basse prédéterminé respectifs, respectivement.

10. Détecteur de tension selon la revendication 9, dans lequel le détecteur de tension élevée comprend un circuit de portes sensible à la tension de référence (Vccx) afin de permettre au circuit de fournir le second signal d'état non prêt.

11. Détecteur de tension selon la revendication 9, dans lequel le circuit de référence (2) comprend :
un circuit de tension de noeud relié à l'entrée de tension élevée, le circuit de tension de noeud ayant un noeud de sortie afin de réduire la tension d'alimentation élevée à une tension de noeud pour le noeud de sortie ; et
un circuit de sélecteur qui fournit la tension de référence (Vccx) en fonction de la plus grande de la tension de noeud ou de la tension d'alimentation.

12. Détecteur de tension selon la revendication 11, dans lequel le circuit de tension de noeud comprend des dispositifs actifs.

13. Détecteur de tension selon la revendication 9, dans lequel le détecteur de basse tension comprend un inverseur de seuil présentant une tension de déclenchement réglée au seuil de basse tension prédéterminé.

14. Détecteur de tension selon la revendication 13, dans lequel l'inverseur de seuil du détecteur de basse tension comprend un dispositif à transistor comportant un canal présentant une longueur et une largeur pour établir la tension de déclenchement pour l'inverseur de seuil du détecteur de basse tension.

15. Détecteur de tension selon la revendication 13, dans lequel le détecteur de basse tension comprend un circuit à hystérésis, relié à l'inverseur de seuil, afin de fournir un premier seuil de tension prédéterminé lorsque l'entrée de basse tension dépasse le premier seuil de tension et un second seuil de tension prédéterminé lorsque l'entrée de basse tension chute en dessous du second seuil de tension.

16. Détecteur de tension selon la revendication 15, dans lequel le détecteur de basse tension comprend un circuit tampon de sortie, relié au circuit d'hystérésis, afin de fournir le premier signal d'état non prêt.

17. Détecteur de tension selon la revendication 13, dans lequel le détecteur de tension élevée comprend un inverseur de seuil présentant une tension de déclenchement réglée au seuil de tension élevée prédéterminé.

18. Détecteur de tension selon la revendication 17, dans lequel l'inverseur de seuil du détecteur de tension élevée comprend un dispositif à transistor comportant un canal présentant une longueur et une largeur pour établir la tension de déclenchement pour l'inverseur de seuil du détecteur de tension élevée.

19. Détecteur de tension selon la revendication 17, dans lequel le détecteur de tension élevée comprend une logique à seuil, reliée à l'inverseur de seuil et au premier signal d'état non prêt, afin de fournir un signal de seuil en réponse à l'inverseur de seuil et au premier signal d'état non prêt.

20. Détecteur de tension selon la revendication 19, dans lequel le détecteur de tension élevée comprend un circuit tampon de sortie sensible au signal de seuil afin de fournir le second signal d'état non prêt.

21. Système de traitement comprenant le détecteur de tension selon la revendication 1, comprenant :
une alimentation destinée à générer une première sortie pour ladite première tension (Vcc) constituant une tension de programmation et une seconde sortie pour ladite seconde tension (Vpp) constituant une tension de lecture ;
une mémoire (520), reliée à l'alimentation, au premier circuit de détection de tension, et au second circuit de détection de tension, qui mémorise des données et des instructions de programme et comporte des circuits sensibles aux premier et second signaux (LVcc, Vpph) pour commander l'accès de la mémoire de sorte que la mémoire ne puisse pas être modifiée lorsque soit le second détecteur de tension détecte le premier signal (LVcc) soit la tension de programmation chute en dessous du second seuil de tension prédéterminé ; et
une unité de traitement (510), reliée à l'alimentation et à la mémoire, qui accède aux données et aux instructions de programme dans la mémoire pour traiter les données et les instructions de programme.

22. Système de traitement selon la revendication 21, dans lequel l'alimentation de référence comprend un circuit de réduction de tension, relié à la tension de programmation de l'alimentation, qui fournit une tension intermédiaire en réponse à la tension de programmation.

23. Système de traitement selon la revendication 22, dans lequel l'alimentation de référence fournit la tension de référence en réponse à la plus grande de la tension intermédiaire ou de la tension de lecture.

24. Système de traitement selon la revendication 21, dans lequel la mémoire comprend une mémoire non volatile qui peut être effacée et programmée lorsque la tension de programmation est appliquée à la mémoire.

25. Système de traitement selon la revendication 24, dans lequel la mémoire non volatile peut être placée dans un mode de lecture seule en réponse au premier signal.

26. Système de traitement selon la revendication 24, dans lequel le second signal désactive les fonctions d'effacement et de programmation de la mémoire.

27. Dispositif de mémoire à circuit intégré comprenant :
une mémoire comportant une pluralité d'emplacements de mémorisation programmables, une entrée de basse tension destinée à recevoir une tension d'alimentation de commande ;
une entrée de tension élevée destinée à recevoir une tension d'alimentation de programmation ;
un circuit de référence (2), relié à l'entrée de tension élevée et à l'entrée de basse tension, comportant un circuit de diviseur destiné à réduire la tension d'alimentation de programmation à une tension de noeud et à fournir une tension de référence à une sortie de circuit de référence en réponse à la plus grande d'une tension de commande ou d'une tension de noeud ;
un circuit de détection de tension d'alimentation de commande, alimenté par la sortie du circuit de référence, et fournissant une sortie d'alimentation de commande, le circuit de détection de tension d'alimentation de commande étant sensible à la tension d'alimentation de commande pour fournir un signal d'alimentation de commande à la sortie d'alimentation de commande qui indique si la tension d'alimentation de commande est au-dessus ou en dessous d'une tension d'alimentation de commande minimum prédéterminée ; et
un circuit de détection de tension d'alimentation de programmation, alimenté par la sortie du circuit de référence et la sortie d'alimentation de commande, et fournissant une sortie d'alimentation de programmation, le circuit de détection de tension d'alimentation de programmation étant sensible à la tension d'alimentation de programmation et au signal d'alimentation de commande pour fournir un signal d'alimentation de programmation à la sortie d'alimentation de programmation avec une indication lorsque la tension d'alimentation de programmation est au-dessus d'une tension d'alimentation de programmation minimum prédéterminée et la tension d'alimentation de commande est au-dessus de la tension d'alimentation de commande minimum prédéterminée, et sinon une autre indication.

28. Dispositif de mémoire à circuit intégré selon la revendication 27, dans lequel le circuit de diviseur comprend des dispositifs actifs pour réduire la tension d'alimentation de programmation à la tension de noeud.

29. Dispositif- de mémoire à circuit intégré selon la revendication 27, dans lequel le circuit de détection de tension d'alimentation de programmation comprend un circuit de portes sensible à la tension de référence pour valider le circuit de détection de tension d'alimentation de programmation lorsque la tension de référence chute à l'intérieur d'une plage prédéterminée en dessous de la tension d'alimentation de programmation.

30. Dispositif de mémoire à circuit intégré selon la revendication 27, dans lequel le circuit de détection de tension d'alimentation de commande comprend un détecteur de seuil présentant un seuil de tension réglé à la tension d'alimentation de commande minimum prédéterminée pour fournir une sortie de seuil.

31. Dispositif de mémoire à circuit intégré selon la revendication 30, dans lequel le détecteur de seuil comprend un inverseur présentant une tension de déclenchement réglée au seuil de tension.

32. Dispositif de mémoire à circuit intégré selon la revendication 31, dans lequel l'inverseur comprend un dispositif à canal p et un dispositif à canal n présentant un canal ayant une longueur et une largeur établies pour la tension de déclenchement.

33. Dispositif de mémoire à circuit intégré selon la revendication 30, dans lequel le circuit de détection de tension d'alimentation de commande comprend un circuit à hystérésis afin de fournir un premier seuil de tension d'alimentation de commande minimum durant une séquence de montée de tension d'alimentation et un second seuil de tension d'alimentation de commande minimum durant une séquence de chute de l'alimentation.

34. Dispositif de mémoire à circuit intégré selon la revendication 33, dans lequel le circuit de détection de tension d'alimentation de commande comprend un circuit de sortie, relié au circuit à hystérésis afin de fournir le signal d'alimentation de commande basse.

35. Dispositif de mémoire à circuit intégré selon la revendication 27, dans lequel le circuit de détection de tension d'alimentation de programmation comprend des circuits comportant des dispositifs actifs pour réduire la tension d'alimentation de programmation à une tension réduite et pour fournir une tension de détection lorsque la tension réduite est supérieure à la tension de référence.

36. Dispositif de mémoire à circuit intégré selon la revendication 35, dans lequel le circuit de détection de tension d'alimentation de programmation comprend un détecteur de seuil présentant un seuil de tension réglé à une tension d'alimentation de programmation minimum prédéterminée afin de fournir une sortie de seuil en réponse à la tension du détecteur.

37. Dispositif de mémoire à circuit intégré selon la revendication 36, dans lequel le détecteur de seuil comprend un inverseur ayant le seuil de tension réglé à la tension d'alimentation de programmation minimum prédéterminée.

38. Dispositif de mémoire à circuit intégré selon la revendication 36, dans lequel le circuit de détection de tension d'alimentation de programmation comprend une logique qui reçoit des entrées provenant du signal d'alimentation de commande basse du circuit de détection de tension d'alimentation de commande et du signal de seuil afin de fournir un signal logique.

39. Dispositif de mémoire à circuit intégré selon la revendication 38, dans lequel le circuit de détection de tension de programmation comprend un circuit tampon de sortie relié à la logique sensible au signal logique pour fournir le signal de programmation bas.
